# FASCICULE DE BREVET EUROPEEN

(11) **EP 1 544 724 B1**
(45) Date de publication et mention de la délivrance du brevet: **05.07.2006**
(21) Numéro de dépôt: 04029809.3
(22) Date de dépôt: 16.12.2004
(51) Int. Cl.: G06F 5/06

(54) **Nouvelle architecture de mémoire FIFO et procédé de gestion d'une telle mémoire**
Neue FIFO Speicherarkitektur und Betriebsverfahren für einen solchen Speicher
New FIFO memory structure and operting procedure of such a memory

(30) Priorité: 19.12.2003 FR 0314960
(43) Date de publication de la demande: 22.06.2005
(73) Titulaire: STMicroelectronics S.A., 92120 Montrouge (FR)
(72) Inventeur: Artieri, Alain, 9, rue Claude Chappe 57070 Metz (FR)
(74) Mandataire: Bentz, Jean-Paul

(56) Documents cités:
- EP-A- 0 483 441
- US-A- 4 779 234
- US-A- 5 371 877
- US-A- 6 067 267

## Description

L'invention concerne une mémoire de type "premier entré, premier sorti", plus couramment appelée mémoire FIFO (First In First Out).

De manière générale, les mémoires FIFO comprennent essentiellement une mémoire de base (ex : de type RAM) de la taille de la mémoire FIFO et incluant ses circuits de lecture / écriture, et des circuits de logique pour gérer le contenu de la FIFO, de sorte que les mots soient lus dans le même ordre qu'ils ont été mémorisés (principe de la mémoire FIFO). Les mémoires FIFO connues sont en général de petite taille (8 à 16 mots de 8 bits).

Les mémoires FIFO les plus utilisées actuellement sont construites sur la base d'une mémoire de base double port, comprenant un port de lecture et un port d'écriture, en entrée et en sortie de la mémoire FIFO. Un exemple d'une telle mémoire est décrit dans le document US 6,144,608. L'inconvénient principal de ces mémoires est leur taille. La présence des deux ports a pour conséquence que la surface de silicium nécessaire à la réalisation d'une FIFO est environ deux fois plus importante que la surface de silicium nécessaire à la réalisation d'une mémoire classique de même capacité (même nombre de mots). Par ailleurs, les points mémoire sont en pratique plus gros et les circuits de logique, nécessaires pour gérer le contenu de la mémoire FIFO et la présence des deux ports de la mémoire de base, sont plus complexes et donc également plus gros que ceux d'une mémoire classique de même capacité. Un autre inconvénient de ces mémoires FIFO est leur fréquence de cadencement (égale au débit de mots en entrée ou en sortie de la FIFO), qui est limitée en pratique par la fréquence de cadencement de la mémoire double port de base utilisée pour les réaliser.

D'autres mémoires FIFO connues sont réalisées sur la base d'une mémoire de base simple port mais utilisée avec une fréquence deux fois plus importante que la fréquence de la mémoire FIFO. Les lectures dans la FIFO sont ainsi réalisées pendant les cycles pairs d'un signal d'horloge cadençant la FIFO, alors que les écritures dans la FIFO sont réalisées pendant les cycles impairs du signal d'horloge. L'inconvénient principal de ces FIFO est qu'il faut utiliser une mémoire de base particulièrement rapide (fréquence importante) pour obtenir une mémoire FIFO ayant une vitesse raisonnable, puisque la fréquence de la FIFO est divisée par deux par rapport à la fréquence de la mémoire de base. Or, les mémoires rapides sont en général chères, car difficiles à réaliser, et également grandes consommatrices d'énergie.

L'invention a pour objet une nouvelle structure de mémoire FIFO ne présentant pas les inconvénients des FIFO connues.

Ainsi, l'invention a pour objet une mémoire FIFO de fréquence f et de taille M mots de n bits, pour mémoriser successivement des mots de n bits reçus en série sur une entrée (DIN) et fournir en série sur une sortie (QOUT) les dits mots dans l'ordre dans lequel ils ont été mémorisés. La mémoire FIFO comprend une mémoire de base (110, 220) de fréquence f/2, apte à mémoriser simultanément deux mots de n bits reçus successivement sur l'entrée (DIN) de la mémoire FIFO. La mémoire FIFO comprend également un circuit de mémorisation (130) pour mémoriser soit un mot de n bits reçu sur l'entrée (DIN) de la mémoire FIFO soit simultanément deux mots de n bits produits par la mémoire de base (110, 220) et pour produire sur la sortie OUT de la mémoire FIFO l'un des mots que le dit circuit de mémorisation (130) mémorise.

Comme on le voit immédiatement, une mémoire FIFO de fréquence f selon l'invention utilise une mémoire de base de fréquence f/2, plus facile à réaliser et moins coûteuse qu'une mémoire de même taille mais de fréquence f. Par ailleurs, la mémoire de base utilisée est une mémoire simple port comme on le verra mieux dans des exemples, ce qui limite encore sa taille.

L'invention concerne également un procédé de gestion du contenu d'une mémoire selon l'invention, au cours duquel, pour mémoriser un mot de n bits dans la mémoire FIFO :
- on mémorise un mot de n bits dans un circuit de mémorisation (130) de la mémoire FIFO si le dit circuit de mémorisation (130) n'est pas plein,
- on mémorise simultanément deux mots de n bits dans une mémoire de base (110, 220) de la mémoire FIFO si le circuit de mémorisation (130) est plein, ou
- on mémorise dans le circuit de mémorisation (130) simultanément deux mots de n bits précédemment mémorisés dans la mémoire de base (110, 220), si deux mots peuvent être mémorisés dans le registre.

Pour sortir un mot de n bits de la mémoire FIFO :
- on lit un mot du circuit de mémorisation (130) si le circuit de mémorisation contient au moins un mot, le mot sorti étant choisi en fonction de l'ordre dans lequel les mots ont été mémorisés dans le circuit de mémorisation, ou
- on lit un mot présent sur l'entrée de la mémoire FIFO sinon.

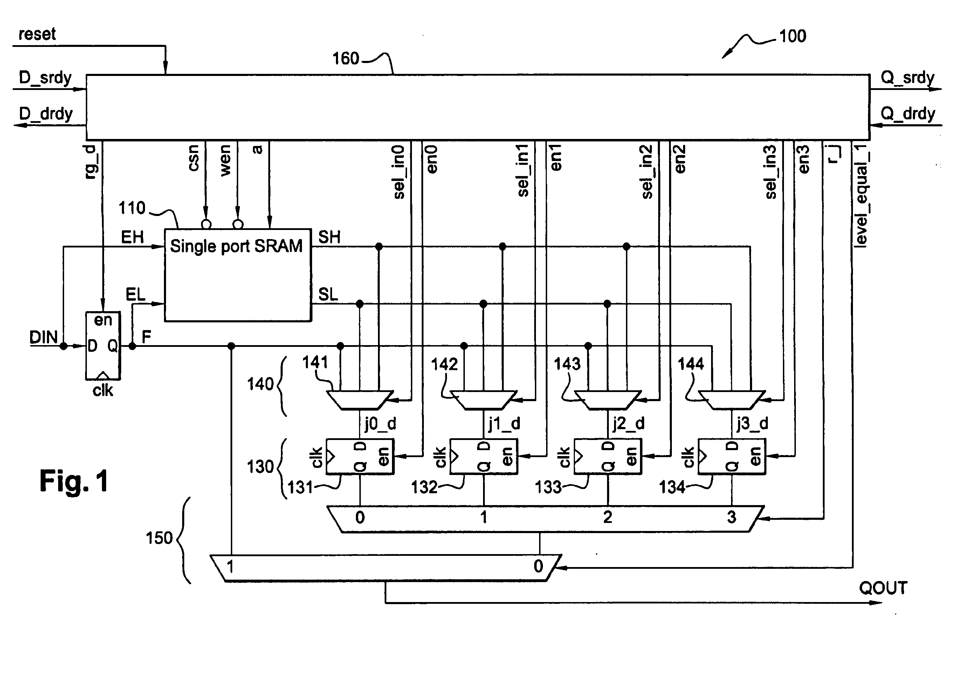

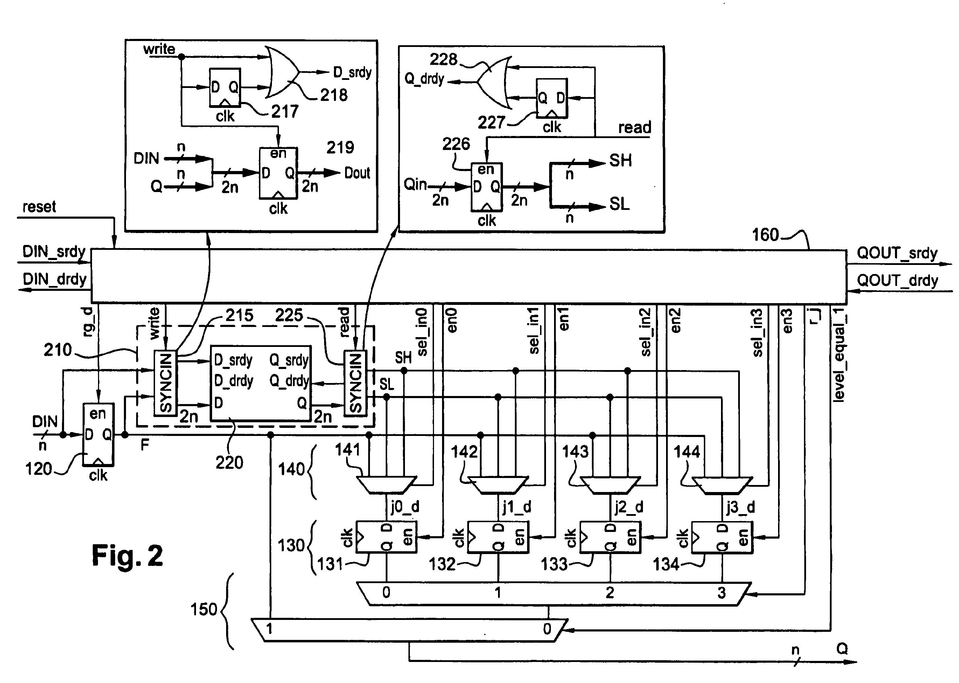

L'invention sera mieux comprise et d'autres caractéristiques et avantages apparaîtront à la lecture de la description qui va suivre, d'exemples de mise en oeuvre d'une mémoire FIFO selon l'invention, représentés sur les figures 1 et 2 annexées. A noter que, par souci de clarté des figures, le même nom est utilisé pour parler d'une entrée ou d'une sortie de la mémoire ou d'un composant de la mémoire d'une part, et pour parler du signal associé produit ou reçu par la mémoire ou le composant, d'autre part.

### I. Premier mode de réalisation de l'invention

Un premier exemple de réalisation d'une mémoire FIFO 100 selon l'invention est représenté sur la figure 1. La mémoire est de taille M * n (M mots de n bits) et a une fréquence f. La mémoire 100 comprend une entrée DIN de donnée de n bits et une sortie QOUT de données de n bits. La mémoire comprend également deux sorties d'information D_DRDY, Q_SRDY, deux entrées de commande D_SRDY, Q_DRDY et une entrée d'initialisation RESET.

Le signal D_SRDY indique à la mémoire qu'une donnée est présente à l'entrée DIN pour être mémorisée. Le signal Q_DRDY indique à la mémoire qu'une donnée doit être présentée (lue) sur la sortie Q. Le signal D_DRDY indique que la mémoire n'est pas pleine (et donc qu'une donnée peut être entrée) et le signal Q_SRDY indique que la mémoire n'est pas vide (et donc qu'une donnée peut être lue sur la sortie Q). Le signal RESET est utilisé pour initialiser la mémoire, c'est-à-dire pour effacer son contenu, pour activer le signal D_DRDY (mémoire non pleine) et désactiver le signal Q_SRDY (mémoire vide).

Le fonctionnement global de la mémoire 100 est le suivant. Lorsque les signaux D_SRDY et D_DRDY sont actifs (en d'autres termes, une donnée de n bits est présente sur l'entrée DIN et la mémoire n'est pas pleine), alors la donnée est mémorisée dans la FIFO. Lorsque les signaux Q_DRDY et Q_SRDY sont actifs (en d'autres termes, une donnée de n bits est attendue sur la sortie QOUT et la mémoire n'est pas pleine), alors la donnée est présentée sur la sortie Q. Les données sont lues sur la sortie QOUT dans le même ordre qu'elles sont entrées sur l'entrée DIN (principe d'une mémoire FIFO.

La mémoire 100 comprend une mémoire RAM 110, un registre 120 de n bits, un circuit de mémorisation 130 comprenant quatre registres 131, 132, 133, 134 de n bits, un circuit de sélection 140 comprenant quatre multiplexeurs 141, 142, 143 et 144, un multiplexeur 150 et un circuit de logique 160. La mémoire 100 est cadencée par un signal d'horloge CLK de fréquence f, qui cadence notamment le registre 120 et le circuit 130.

La mémoire 110 de base est une mémoire RAM, par exemple de type SRAM, à un seul port parallèle de 2*n bits, comprenant une entrée de données et une sortie de données de 2*n bits. La mémoire 110 reçoit un signal de validation (CSN), un signal de commande WEN indiquant si une écriture (WEN actif) ou une lecture (WEN inactif) doit être réalisée lorsque le signal CSN est actif et un signal ADD indiquant l'adresse à laquelle deux mots de données doivent être écrits ou lus selon le cas. La mémoire 110 a une capacité de (M-3)/2 mots de 2*n bits et a une fréquence égale à f/2, c'est-à-dire qu'elle peut mémoriser ou fournir un mot de 2*n bits (ou deux mots de n bits en parallèle) tous les deux cycles du signal CLK.

Le registre 120 est un registre de n bits, comprenant une entrée D parallèle de données de n bits connectée à l'entrée DIN de la mémoire FIFO 100 et connectée également aux n bits de poids forts EH de l'entrée de la mémoire 110, une sortie Q parallèle de n bits connectée aux n bits de poids faibles EL de l'entrée de la mémoire 110. Lorsque le registre 120 reçoit un signal de validation RG_D et un front actif du signal d'horloge CLK, il recopie sur sa sortie Q la donnée présente sur son entrée D. Les registres 131, 132, 133, 134 sont identiques au registre 120. Lorsque le registre 131, respectivement 132, 133, 134, reçoit un front actif du signal d'horloge CLK et un signal de validation EN0, respectivement EN1, EN2, EN3, le registre 131, respectivement 132, 133, 134 recopie sur sa sortie Q la donnée présente sur son entrée D.

L'entrée D de données du registre 131, respectivement 132, 133, 134, est connectée à une sortie du multiplexeur 140, respectivement 141, 142, 143. Chaque multiplexeur 140, 141, 142, 143 a trois entrées parallèles de n bits, connectées respectivement aux n bits de poids forts SH de la sortie de la mémoire 110, aux bits de poids faibles SL de la sortie de la mémoire 110 et à la sortie de n bits du registre 120. Chaque multiplexeur fournit sur sa sortie une donnée qu'il reçoit sur l'une ou l'autre de ses entrées en fonction d'un signal de sélection SEL_IN0, SEL_IN1, SEL_IN2, SEL_IN3. Le multiplexeur 150 comprend quant à lui cinq entrées parallèles de n bits, chacune connectée à la sortie d'un registre 120, 131, 132, 133 ou 134, et une sortie parallèle de n bits formant la sortie QOUT de la mémoire FIFO. Le multiplexeur 150 fournit sur sa sortie une donnée qu'il reçoit sur l'une de ses cinq entrées en fonction des signaux de sélection R_J et LEVEL_EQUAL_1.

Enfin, à partir des signaux D_SRDY, Q_DRDY, RESET, le circuit de logique 160 gère le fonctionnement de la mémoire FIFO, en produisant l'ensemble des signaux de commande de la mémoire RAM 110, des registres 120, 131, 132, 133, 134, des multiplexeurs 140, 141, 142, 143, 150 et produit les signaux de sortie D_DRDY et Q_SRDY, de sorte à assurer un fonctionnement global de la mémoire tel que détaillé ci-dessous. Le circuit 160 gère également les priorités des commandes de la mémoire FIFO ; par exemple, au cours d'un même cycle d'horloge, si une condition d'écriture et une condition de lecture sont reçues simultanément, alors on effectue d'abord l'écriture, puis la lecture. Enfin, le circuit 160 tient à jour le niveau LEVEL de FIFO, c'est-à-dire le nombre de mots de données contenus dans la mémoire 100. On note RG_D le signal actif indiquant qu'un mot est mémorisé dans la mémoire 100 et on note RG_Q le signal actif indiquant qu'un mot est sorti de la mémoire 100 (mot lu sur la sortie Q). Après chaque écriture / lecture, LEVEL est mis à jour selon les relations suivantes :
- LEVEL = 0 si RESET est actif
- LEVEL = LEVEL + RG_D - RG_Q sinon

Le circuit de logique 160, la mémoire 110 et les registres 120, 131, 132, 133, 134 sont synchronisés et cadencés par un signal d'horloge CLK (le circuit d'horloge n'est pas représenté par souci de clarté).

Le fonctionnement détaillé de la mémoire FIFO selon l'invention est le suivant.

### 1. Ecriture de plusieurs mots dans la mémoire FIFO

On suppose ici que la mémoire 100 est initialisée par un signal RESET actif ; la mémoire 100 est donc vide (mémoire 110 et registres 120, 131, 132, 133, 134 vides) et le niveau LEVEL est égal à 0.

Lorsque les signaux D_DRDY et D_SRDY sont actifs, un premier mot est présent à l'entrée DIN de la mémoire 100. Il est mémorisé sur un front actif de CLK ; plus précisément, il est recopié immédiatement sur la sortie QOUT de la mémoire FIFO (libre) par l'intermédiaire du registre 120. Le niveau LEVEL passe à 1.

Lorsque les signaux D_DRDY et D_SRDY sont à nouveau actifs, un deuxième mot présent sur l'entrée DIN est mémorisé dans la FIFO sur un front actif de CLK ; plus précisément, la sortie QOUT de la mémoire FIFO n'étant pas libre (le premier mot n'ayant pas encore été lu), le deuxième mot est mémorisé dans le registre 131 par l'intermédiaire du registre 120 et du multiplexeur 141. Le niveau LEVEL passe à 2.

Lorsque les signaux D_DRDY et D_SRDY sont à nouveau actifs, un troisième mot présent sur l'entrée DIN est mémorisé dans la FIFO sur un front actif de CLK ; plus précisément, la sortie QOUT de la mémoire FIFO n'étant pas libre (le premier mot n'ayant pas encore été lu) et le registre 131 étant occupé (le deuxième mot est toujours mémorisé dans le registre 131), le deuxième mot est mémorisé dans le registre 132 par l'intermédiaire du registre 120 et du multiplexeur 141, et le niveau LEVEL passe à 3. Un quatrième mot et un cinquième mot sont mémorisés de manière similaire dans les registres 133, 134 par l'intermédiaire des multiplexeurs 142, 143. Le niveau LEVEL passe à 4 puis à 5. Lors de la mémorisation du cinquième mot dans le registre 134, un sixième mot est placé en sortie du registre 120, sur le même front d'horloge.

Les signaux D_DRDY et D_SRDY étant à nouveau actifs et LEVEL étant égal à 5, lors du front d'horloge actif suivant, le sixième mot de données, présent en sortie du registre 120, et le septième mot de données, présent sur l'entrée du registre 120, sont mémorisés simultanément dans la mémoire 110. LEVEL est incrémenté à 7. Les mots suivants présentés sur l'entrée DIN sont ensuite mémorisés deux par deux, tous les deux fronts actifs du signal d'horloge et le niveau LEVEL est incrémenté en conséquence.

### 2. Lecture de plusieurs mots dans la mémoire FIFO

On suppose ici qu'initialement un nombre important de mots ont été mémorisés dans la mémoire FIFO tel que décrit ci-dessus ; en particulier, le premier mot est présent sur la sortie QOUT de la mémoire FIFO, les quatre mots suivants sont mémorisés dans les registres 131 à 134 et les mots suivants sont mémorisés, par paires de mots, dans la mémoire RAM 110. Le signal Q_SRDY est actif puisque la mémoire n'est pas vide.

Lorsque le signal Q_DRDY est actif, le premier mot est lu sur la sortie QOUT de la mémoire FIFO et le niveau LEVEL est décrémenté de 1. Lors du prochain front actif du signal d'horloge, le deuxième mot, mémorisé dans le registre 131, est positionné sur la sortie QOUT de la mémoire FIFO. Le deuxième mot est lu sur la sortie QOUT de la mémoire, LEVEL est décrémenté de 1 et le troisième mot, présent dans le registre 132, est placé sur la sortie QOUT de la mémoire FIFO.

Les deux registres 131, 132 étant devenus libres, une paire de mots présents dans la mémoire 110 sont mémorisés dans les registres 131, 132 par l'intermédiaire des multiplexeurs 140, 141 (WEN actif, mémoire RAM commandée en lecture).

Les mots mémorisés dans les registres 133, 134 sont ensuite positionnés successivement sur la sortie QOUT au fil des instructions de lecture Q_DRDY actif). Dès que les registres 133, 134 sont vidés, deux mots sont lus dans la mémoire 110 et mémorisés dans les registres 133, 134. A chaque fois qu'un mot est lu sur la sortie QOUT de la mémoire FIFO, LEVEL est décrémenté en conséquence.

### 3. Ecriture / lecture dans la mémoire FIFO, Synthèse

Un mot à écrire dans la mémoire FIFO 100 est écrit :
- sur la sortie QOUT de la mémoire FIFO si elle est libre, ou
- dans le premier registre libre parmi les registres 131, 132, 133, 134 si la sortie QOUT n'est pas libre et si au moins un des registres 131, 132, 133, 134 est libre, ou
- dans la mémoire 110 sinon, les mots étant toujours mémorisés par paire dans la mémoire 110.

Le premier mot à lire est positionné immédiatement sur la sortie QOUT de la mémoire. Les autres mots à lire sont positionnés successivement sur la sortie QOUT de la mémoire et sont issus de l'un ou l'autre des registres 131, 132, 133 ou 134. Dès que deux registres parmi les registres 131, 132, 133, 134 sont libres, et si la mémoire 110 n'est pas vide, alors deux mots de la mémoire 110 sont prépositionnés dans les registres vides 131, 132, 133 ou 134, en attente d'être positionnés sur la sortie QOUT de la mémoire FIFO. Le niveau LEVEL est incrémenté / décrémenté au fur et à mesure des écritures / lectures dans la FIFO.

On notera que, pour réaliser une FIFO telle que celle de la figure 1 et de fréquence f (vitesse d'entrée des mots sur l'entrée DIN ou de sortie des mots sur la sortie QOUT), il est suffisant d'utiliser une mémoire de base 110 de fréquence égale à f/2, puisque les mots sont écrits / lus dans la mémoire 110 deux à deux. La fréquence étant plus faible, la mémoire est plus facile à réaliser. Par ailleurs, l'expérience montre que la surface de silicium nécessaire pour une mémoire FIFO de taille M*n selon la figure 1 est réduite d'environ 40% (notamment diminution de la taille des points mémoire, un seul port de communication) par rapport à celle nécessaire pour une mémoire FIFO de même taille M*n selon l'art antérieur utilisant une RAM double-port.

Par ailleurs, dans l'exemple de la figure 1, le circuit de mémorisation 130 comprend quatre registres 131 à 134. Cette solution permet de lire immédiatement un mot dans la FIFO dès qu'un signal de lecture est reçu, car, pour autant que la mémoire FIFO ne soit pas vide, il y a toujours un mot soit dans l'un des registres 131 à 134 soit dans le registre 120, donc prêt à être lu. On notera que dans ce cas, une commande de lecture de la FIFO (en pratique d'un registre 120, 131 à 134) peut être exécutée simultanément avec une commande d'écriture de la FIFO (en pratique une écriture dans un de registres ou dans la mémoire de base 110.

Il serait possible d'utiliser un circuit 130 comportant moins de registres, par exemple seulement deux ou trois. On obtiendra ainsi une mémoire FIFO de taille légèrement plus petite (un ou deux registres en moins). Cependant, dans certaines circonstances particulières, il faut s'attendre à ce qu'une commande de lecture dans la FIFO ne puisse être exécutée immédiatement parce que le circuit de mémorisation 130 est vide alors que la FIFO elle-même n'est pas vide. Cela pourra être le cas si plusieurs commande successives d'écritures dans la mémoire de base sont activées, empêchant l'exécution d'une commande de lecture de la mémoire de base pour charger le circuit de mémorisation 130. (on rappelle que la mémoire 110 est une mémoire simple port, c'est-à-dire qu'il n'est pas possible de réaliser simultanément une écriture et une lecture de la mémoire 110).

Il serait également possible d'utiliser un circuit 130 comprenant plus de quatre registres. Ceci présente peu d'intérêt dans la mesure où les performances de la FIFO ne seraient pas améliorées, puisque avec quatre registres, il n'y a déjà pas d'attende en lecture.

### II. Deuxième mode de réalisation de l'invention

Un deuxième exemple d'une mémoire FIFO selon l'invention est représenté sur la figure 2. D'un point de vue global externe, elle est identique à celle de la figure 1 : elle possède une entrée DIN et une sortie QOUT de données de n bits, elle reçoit deux signaux de commande D_SRDY et Q_DRDY, et son fonctionnement global est le même. La mémoire 200 a également une capacité de M mots de n bits et une fréquence f.

La mémoire FIFO 200 se distingue de la mémoire 100 de la figure 1 par le fait que la mémoire de base 110 de type RAM a été remplacée par une mémoire de base 210 comprenant un circuit d'entrée 215, une mémoire 220 et un circuit de sortie 225.

La mémoire 220 est une mémoire FIFO selon l'invention, similaire à la mémoire 100 de la figure 1, et ayant les caractéristiques suivantes : la mémoire 220 traite des mots de 2*n bits et peut mémoriser jusqu'à (M-1)/2 - 1 mots de 2*n bits. La mémoire 220 a une fréquence égale à f/2, f étant la fréquence de la mémoire 200. La mémoire FIFO 220 comprend une mémoire RAM de (M-1) /4 - 2 mots de 4*n bits et a une fréquence égale à f/4. La mémoire 220 comprend également un registre 120, un circuit de mémorisation 130 comprenant quatre registres 131, 132, 133, 134 de 2*n bits, et un circuit de sélection 140 et un multiplexeur 150 de tailles appropriées pour gérer des mots de 2*n bits.

Le circuit 215 d'entrée est connecté entre d'une part l'entrée et la sortie du registre 120 et d'autre part l'entrée de données de la mémoire 220. Le circuit 215 a pour objet, lorsqu'un signal WRITE d'écriture dans la mémoire 220 est reçu, d'associer les mots de n bits reçus sur l'entrée DIN de la mémoire FIFO de sorte à fournir des mots de 2*n bits sur l'entrée de la mémoire 220.

Le circuit 215 comprend un registre 216 de 2*n bits, un registre 217 de 1 bit et une porte logique 218. Le registre 216 comprend deux entrées parallèles de n bits chacune, connectées respectivement à l'entrée DIN de la mémoire 200 et à la sortie Q du registre 120. Le signal d'écriture WRITE est appliqué sur une entrée de validation du registre 216, sur une entrée de donnée du registre 217 et sur une entrée de la porte 218. La porte 218 est de type OU et comprend également une deuxième entrée connectée à la sortie du registre 217 et une sortie sur laquelle est produit le signal de commande DOUT_SRDY appliqué sur la mémoire 220.

Le circuit 225 de sortie est connecté entre d'une part la sortie de la mémoire 220 et d'autre part les entrées des multiplexeurs 241, 242, 243, 244. Le circuit 225 a pour objet, lorsqu'un signal READ de lecture de la mémoire 220 est reçu, de dissocier les mots de 2*n bits sortis de la mémoire 220 pour produire des mots de n bits.

Le circuit 225 comprend un registre 226 ayant une entrée QIN de données de 2*n bits connectée à la sortie Q de la mémoire 220 et deux sorties QH, QL parallèles de données de n bits chacune, connectées chacune à une entrée des entrées de chaque multiplexeur 141, 142, 143, 144. Le registre 226 comprend également une entrée de validation sur laquelle est appliqué le signal READ. La porte 228 est dans l'exemple de type ET, et comprend une sortie sur laquelle est produit un signal de validation Q_DRDY appliqué sur une des entrées de validation de la mémoire 220. La porte 228 comprend également une entrée sur laquelle est appliqué le signal READ et une entrée connectée à la sortie de donnée du registre 227 qui est cadencé par le signal d'horloge CLK. La porte ET produit le signal Q_DRDY qui est appliqué sur une entrée de validation de la mémoire 220. Un cycle d'horloge après l'activation du signal READ, la porte 228 produit le signal Q_DRDY (retard à l'activation du au registre 227) qui active la sortie d'une donnée de la mémoire 220, la donnée sortie étant appliquée à l'entrée du registre 226. Comme le signal READ est actif, ladite donnée est présentée immédiatement sur la sortie du registre 226.

On notera que, pour réaliser une FIFO telle que celle de la figure 2 et de fréquence f (vitesse d'entrée des mots sur l'entrée D ou de sortie des mots sur la sortie Q), il est suffisant d'utiliser une mémoire RAM (qui est utilisée pour réaliser la FIFO 220 selon le mode de réalisation de la figure 1) de fréquence égale à f/4, puisque les mots sont écrits / lus dans la mémoire 220 deux à deux, et donc dans la RAM quatre par quatre.

### III. Autres modes de réalisation d'une FIFO selon l'invention

La FIFO 200 selon la figure 2 se distingue de la FIFO 100 selon la figure 1, toutes deux de même taille M*n et de même fréquence f, par le fait que la RAM 110 (de taille [(M-1)/2-1]*2n et de fréquence f/2) a été a été remplacée par une FIFO 220 de taille [(M-1)/2-1]*2n = [(M-1)/2¹⁻1]*2¹.n, de fréquence f/2 et utilisant elle-même une RAM de taille [(M-1)/2²-2]*2².n et de fréquence f/4. La FIFO 220 de la figure 2 peut être réalisée conformément à la figure 1 ; elle peut aussi être réalisée selon la figure 2, c'est-à-dire elle-même à partir d'une FIFO selon l'invention.

Ainsi, une autre FIFO selon l'invention de taille M*n et de fréquence f peut être réalisée en utilisant :
- une FIFO selon l'invention de taille [(M-1)/2¹-1]*2¹.n, de fréquence f/2, cette FIFO comprenant :

- une FIFO selon l'invention de taille [(M-1)/2²⁻2]^{*}2².n et de fréquence f/4, cette FIFO comprenant :

- une mémoire RAM de taille [(M-1)/2³-2]*2³.n et de fréquence f/2³.

Cette idée donne la possibilité d'utiliser des RAM de vitesse (ou fréquence) très faible pour réaliser des FIFO très rapides, ce qui a bien sûr un effet très positif sur la taille de la FIFO globale et sur sa consommation énergétique.

Ainsi, pour réaliser une FIFO de fréquence f, apte à mémoriser M mots (longueur de la FIFO) de n bits (largeur de la FIFO, on pourra utiliser :
- un RAM de fréquence f/2, apte à mémoriser (M-1)/2 - 1 mots de 2*n bits, conformément à la figure 1, ou
- une RAM de fréquence f/4, apte à mémoriser (M-1)/4 - 2 mots de 4*n bits, conformément à la figure 2, ou
- une RAM de fréquence f/8, apte à mémoriser (M-1)/2³ - 3 mots de 8*n bits, il suffit pour cela de réaliser une FIFO similaire à celle de la figure 2, en remplaçant simplement la mémoire 220 de la figure 2 par une mémoire similaire à celle de la figure 2 mais de taille (M-1)/2 - 1 mots de 2*n bits
- ou plus généralement une RAM de fréquence f/2^{(p-1)} apte à mémoriser (M-1)/2^{(p-1)} - (p-1) mots de 2^{(p-1)}*n bits.

Finalement, pour un ensemble de paramètres donnés (largeur des mots, nombre de mots, débit des mots de la mémoire FIFO globale et vitesse de la RAM utilisée), on réalisera une FIFO utilisant un nombre d'étages (= nombre de FIFO selon l'invention imbriquées) choisi pour avoir un bon compromis entre la taille de la mémoire FIFO globale, sa consommation d'énergie, la fréquence f souhaitée.

## Revendications

1. Mémoire FIFO de fréquence f et de taille M mots de n bits, pour mémoriser successivement des mots de n bits reçus en série sur une entrée (DIN) et fournir en série sur une sortie (QOUT) les dits mots dans l'ordre dans lequel ils ont été mémorisés, la mémoire FIFO comprenant une mémoire de base (110, 220) de fréquence f/2, apte à mémoriser simultanément deux mots de n bits reçus successivement sur l'entrée (DIN) de la mémoire FIFO, charactériser en ce que la mémoire FIFO comprenant un circuit de mémorisation (130) pour mémoriser soit un mot de n bits reçu sur l'entrée (DIN) de la mémoire FIFO soit simultanément deux mots de n bits produits par la mémoire de base (110, 220) et pour produire sur la sortie (QOUT) de la mémoire FIFO l'un des mots que le dit circuit de mémorisation (130) mémorise.

2. Mémoire selon la revendication 1, dans laquelle le circuit de mémorisation comprend K registres de n bits et un circuit de sélection 140 pour mémoriser dans l'un ou l'autre des registres soit un mot de n bits reçus sur l'entrée (DIN) de la FIFO soit simultanément deux mots de n bits produits par la mémoire de base (110, 220).

3. Mémoire selon la revendication 2, dans laquelle le circuit de mémorisation (130) mémorise au plus quatre mots de n bits.

4. Mémoire selon l'une des revendication 1 à 3, dans laquelle la mémoire de base est une mémoire de type RAM (110).

5. Mémoire selon l'une des revendications 1 à 3, de taille M mots de n bits, dans laquelle la mémoire de base comprend une mémoire FIFO de base (210) de taille [(M-1)/2-1] mots de 2*n bits et de fréquence f/2.

6. Mémoire selon la revendication 5, dans laquelle la mémoire FIFO de base (210) comprend une mémoire RAM (110) de taille [(M-1)/2^{(p-1)}-(p-1)] mots de 2^{(p-1)}*n bits ayant une fréquence égale à f/2^{(p-1)}, p étant un nombre entier supérieur ou égal à un.

7. Procédé de gestion du contenu d'une mémoire FIFO, au cours duquel, pour mémoriser un mot de n bits dans la mémoire FIFO :
• on mémorise un mot de n bits dans un circuit de mémorisation (130) de la mémoire FIFO si le dit circuit de mémorisation (130) n'est pas plein,
• on mémorise simultanément deux mots de n bits dans une mémoire de base (110, 220) de la mémoire FIFO si le circuit de mémorisation (130) est plein, ou
• on mémorise dans le circuit de mémorisation (130) simultanément deux mots de n bits précédemment mémorisés dans la mémoire de base (110, 220), si deux mots peuvent être mémorisés dans le registre.

8. Procédé selon la revendication 7, au cours duquel, pour sortir un mot de n bits de la mémoire FIFO :
• on lit un mot du circuit de mémorisation (130) si le circuit de mémorisation contient au moins un mot, le mot sorti étant choisi en fonction de l'ordre dans lequel les mots ont été mémorisés dans le circuit de mémorisation, ou
• on lit un mot présent sur l'entrée de la mémoire FIFO sinon.

## Claims

1. FIFO memory of frequency f and size M words of n bits, in order to successively store words of n bits received in series at an input (DIN) and supply the said words in series at an output (QOUT) in the order in which they were stored, the FIFO memory comprising a base memory (110, 220) of frequency f/2, able to simultaneously store two words of n bits received successively at the input (DIN) of the FIFO memory, **characterised in that** the FIFO memory comprising a storage circuit (130) for storing either a word of n bits received at the input (DIN) of the FIFO memory or simultaneously two words of n bits produced by the base memory (110, 220) and for producing at the output (QOUT) of the FIFO memory one of the words that the said storage circuit (130) stores.

2. Memory according to claim 1, in which the storage circuit comprises K registers of n bits and a selection circuit 140 for storing, in one or other of the registers, either an n-bit word received at the input (DIN) of the FIFO or simultaneously two n-bit words produced by the base memory (110, 220).

3. Memory according to claim 2, in which the storage circuit (130) stores no more than four n-bit words.

4. Memory according to one of claims 1 to 3, in which the base memory is a memory of the RAM type (110).

5. Memory according to one of claims 1 to 3 of size M words of n bits, in which the base memory comprises a base FIFO memory (210) of size [(M-1)/2-1] words of 2*n bits and of frequency f/2.

6. Memory according claim 5, in which the base FIFO memory (210) comprises a RAM memory (110) of size [(M-1)/2^{(p-1)}-(p-1)] words of 2^{(p-1)}*n bits having a frequency equal to f/2^{(p-1)}, p being an integer greater than or equal to 1.

7. Method of managing the content of a FIFO memory, during which, in order to store an n-bit word in the FIFO memory:
• an n-bit word is stored in a storage circuit (130) of the FIFO memory if the said storage circuit (130) is not full,
• two n-bit words are stored simultaneously in a base memory (110, 220) of the FIFO memory if the storage circuit (130) is full, or
• two n-bit words previously stored in the base memory (110, 220) are stored in the storage circuit (130) simultaneously if two words can be stored in the register.

8. Method according to claim 7, during which, in order to take an n-bit word out of the FIFO memory:
• a word of the storage circuit (130) is read if the storage circuit contains at least one word, the word taken out being chosen according to the order in which the words were stored in the storage circuit, or
• a word present at the input of the FIFO memory is read otherwise.

## Patentansprüche

1. FIFO-Speicher, der für eine Frequenz f ausgelegt ist und eine Größe von M Worten à n Bits aufweist, um Worte mit n Bits hintereinander abzuspeichern, die seriell über einen Eingang (DIN) eingelesen wurden, und um die besagten Worte über einen Ausgang (QOUT) in der Reihenfolge seriell auszugeben, in welcher sie abgespeichert wurden, wobei der FIFO-Speicher einen Basisspeicher (110, 220) umfasst, der für die Frequenz f/2 ausgelegt ist und geeignet ist, gleichzeitig zwei Worte à n Bits abzuspeichern, die nacheinander über den Eingang (DIN) des FIFO-Speichers eingelesen wurden,
**dadurch gekennzeichnet, dass** der FIFO-Speicher umfasst:
einen Speicherschaltkreis (130), um entweder ein Wort à n Bits, das über den Eingang (DIN) des FIFO-Speichers eingelesen wurde, oder gleichzeitig zwei Worte à n Bits, die von dem Basisspeicher (110, 220) ausgegeben wurden, abzuspeichern und um über den Ausgang (QOUT) des FIFO-Speichers eines der Worte, das in dem besagten Speicherschaltkreis (130) abgespeichert wurde, auszugeben.

2. Speicher nach Anspruch 1, in welchem der Speicherschaltkreis K Register à n Bits und einen Auswahlschaltkreis 140 umfasst, um in dem einen oder dem anderen der Register entweder ein Wort à n Bits, das über den Eingang (DIN) des FIFO eingelesen wurde, oder gleichzeitig zwei Worte à n Bits, die von dem Basisspeicher (110, 220) ausgegeben wurden, abzuspeichern.

3. Speicher nach Anspruch 2, bei welchem der Speicherschaltkreis (130) höchstens vier Worte à n Bits abspeichert.

4. Speicher nach einem der Ansprüche 1 bis 3, bei welchem der Basisspeicher ein RAM-Speicher (110) ist.

5. Speicher nach einem der Ansprüche 1 bis 3, mit einer Größe von M Worten à n Bits, bei welchem der Basisspeicher einen FIFO-Basisspeicher (210) mit einer Größe von [(M-1)/2-1] Worten à 2 * n Bits und einer Frequenz f/2 umfasst.

6. Speicher nach Anspruch 5, bei welchem der FIFO-Basisspeicher (210) einen RAM-Speicher (110) mit einer Größe von [(M-1)/2^{(p-1)} - (p-1)] Worten à 2^{(p-1)} * n Bits und einer Frequenz f/2^{(p-1)} umfasst, wobei p eine ganze Zahl größer oder gleich 1 ist.

7. Verfahren zum Verwalten des Inhalts eines FIFO-Speichers, wobei zum Abspeichern eines Wortes à n Bits in dem FIFO-Speicher:
ein Wort à n Bits in einem Speicherschaltkreis (130) des FIFO-Speichers abgespeichert wird, wenn der besagte Speicherschaltkreis (130) nicht voll ist,
gleichzeitig zwei Worte à n Bits in einem Basisspeicher (110, 220) des FIFO-Speichers abgespeichert werden, wenn der Speicherschaltkreis (130) voll ist, oder
in dem Speicherschaltkreis (130) gleichzeitig zwei Worte à n Bits abgespeichert werden, die vorher in dem Basisspeicher (110, 220) abgespeichert wurden, wenn zwei Worte in dem Register abgespeichert werden können.

8. Verfahren nach Anspruch 7, bei dem zum Ausgeben eines Wortes à n Bits aus dem FIFO-Speicher:
ein Wort des Speicherschaltkreises (130) gelesen wird, wenn der Speicherschaltkreis wenigstens ein Wort enthält, wobei das Ausgangswort in Abhängigkeit von der Reihenfolge ausgewählt wird, in welcher die Worte in dem Speicherschaltkreis abgespeichert wurden, oder
anderenfalls ein Wort gelesen wird, das am Eingang des FIFO-Speichers anliegt.
